(19) Europäisches Patentamt
European Patent Office
Office européen des brevets

(11) Veröffentlichungsnummer: **0 145 653**
**B1**

(12) # EUROPÄISCHE PATENTSCHRIFT

(45) Veröffentlichungstag der Patentschrift: **22.04.87**

(51) Int. Cl.⁴: **C 08 G 59/68**, C 08 F 2/50, C 08 G 85/00, G 03 C 1/68

(21) Anmeldenummer: **84810520.1**

(22) Anmeldetag: **29.10.84**

(54) **Photopolymerisierbare Zusammensetzungen.**

(30) Priorität: **03.11.83 GB 8329395**

(43) Veröffentlichungstag der Anmeldung: **19.06.85 Patentblatt 85/25**

(45) Bekanntmachung des Hinweises auf die Patenterteilung: **22.04.87 Patentblatt 87/17**

(84) Benannte Vertragsstaaten: **BE CH DE FR GB IT LI NL SE**

(56) Entgegenhaltungen:
**CHEMICAL ABSTRACTS, Band 82, Nr. 1, 6. Januar, 1975, Seite 365, COLUMBUS, OHIO, (US). Nr. 4204k. B. KARELE et al.: "Iodonium derivatives of some heterocyclic compounds".**
**CHEMICAL ABSTRACTS, Band 79, Nr. 5, 6. august, 1973, Seite 453, Nr. 32003a, COLUMBUS, OHIO, (US). B. KARELE et al.: "Iodonium derivatives of heterocyclic compounds. II. Phenyliodonium salts and uracil betaine".**

(73) Patentinhaber: **CIBA-GEIGY AG, Klybeckstrasse 141, CH-4002 Basel (CH)**

(72) Erfinder: **Goodin, Jonathan William, Dr., 2 Westland Terrace North Street, Cambridge CB4 3QT (GB)**
Erfinder: **Irving, Edward, Dr., 41, Swaffham Road Burwell, Cambridge CB5 0AN (GB)**

EP 0 145 653 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Vorliegende Erfindung betrifft ein kationisch polymerisierbares Material und ein Monoaryljodoniumsalz enthaltende Zusammensetzungen sowie die Polymerisation solcher Zusammensetzungen mittels aktinischer Strahlung und deren Verwendung als Oberflächenbeschichtungen, bei der Herstellung von Druckplatten und gedruckten Schaltungen und als Klebstoffe.

Bekanntlich ist es wünschenswert, die Polymerisation in organischen Materialien mittels aktinischer Strahlung einzuleiten. Mit solchen Verfahren kann man beispielsweise die Verwendung toxischer und/oder brennbarer Lösungsmittel mit ihren begleitenden Problemen der Umweltbelastung und der Rückgewinnungskosten vermeiden. Photopolymerisation ermöglicht es, die Unlöslichmachung von Harzzusammensetzungen auf bestimmte Stellen zu beschränken, d.h. die bestrahlten Stellen, und gestattet daher die Herstellung von gedruckten Schaltungen und Druckplatten bzw. erlaubt es, die Verklebung von Substraten auf die erforderlichen Zonen zu begrenzen. Ferner sind Bestrahlungsverfahren häufig schneller als solche, bei denen Erhitzen und folglich eine Abkühlungsstufe erforderlich sind.

Die Verwendung von Diaryljodoniumsalzen als Photopolymerisationskatalysatoren für kationisch polymerisierbare Materialien ist schon bekannt.

So beschreibt die britische Patentschrift Nr. 1 516 351 härtbare Zusammensetzungen, die aus (A) einem zu einem höheren Molekulargewichtszustand polymerisierbaren Monoepoxid, Epoxidharz oder einem Gemisch von diesen und (B) einem strahlungsempfindlichen Haloniumsalz in einer Menge bestehen, welche die Härtung von (A) durch Freisetzung eines sauren Katalysators bei Belichtung mit Strahlungsenergie bewirken kann.

Typische solche Diarylhaloniumsalze sind Diphenyljodonium-tetrafluoroborat, -hexafluorophosphat, -hexafluoroantimonat und -hexafluoroarsenat.

In der britischen Patentschrift Nr. 1 491 539 sind photopolymerisierbare Zusammensetzungen beschrieben, die aus (A) einem kationisch polymerisierbaren organischen Material und (B) 0,5 bis 30 Teilen auf 100 Gewichtsteile organisches Material eines aromatischen Jodoniumkomplexsalzphotoinitiators der Formel

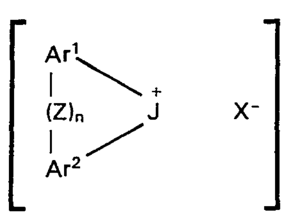 I

worin $Ar^1$ und $Ar^2$ aromatische Gruppen mit 4 bis 20 Kohlenstoffatomen, wie gegebenenfalls substituierte oder gegebenenfalls mit einem oder mehreren Benzoringen kondensierte Phenyl-, Thienyl-, Furanyl- oder Pyrazolylgruppen, und Z ein Sauerstoff- oder Schwefelatom oder eine Gruppe der Formel S=O, C=O, O=S=O oder R-N (wobei R für -H, eine Niederalkylgruppe oder eine Carbonsäureacylgruppe steht), eine direkte Kohlenstoff-Kohlenstoffbindung oder eine Gruppe der Formel $R^1$-C-$R^2$ (wobei $R^1$ und $R^2$ je für -H, Alkyl oder Alkenyl stehen) bedeuten, n null oder 1 ist und $X^-$ ein Tetrafluoroborat-, Hexafluorophosphat-, Hexafluoroarsenat-, Hexachloroantimonat- oder Hexafluoroantimonatanion darstellt, bestehen.

Die angeführten kationisch polymerisierbaren organischen Materialien umfassen Oxetane, Lactone, Vinyläther und Mono- oder Polyepoxide, und als typische Jodoniumkomplexsalze sind wiederum Diphenyljodonium-tetrafluoroborat, -hexachloroantimonat, -hexafluoroantimonat und -hexafluorophosphat angegeben.

Aus der britischen Patentschrift Nr. 1 539 192 sind photopolymerisierbare Zusammensetzungen bekannt, die mindestens ein säurepolymerisierbares oder säurehärtbares Material und als Photosensibilisator mindestens ein Jodoniumsalz der Formel

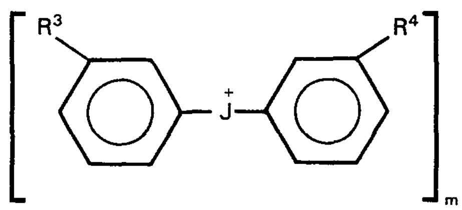 $X'^{m-}$ II

worin m 1 oder 2 ist, $R^3$ und $R^4$ je für ein Wasserstoff- oder Halogenatom, eine Nitrogruppe, eine gegebenenfalls substituierte Kohlenwasserstoffgruppe oder eine heterocyclische Gruppe und $X'^{m-}$ für ein sich von einer zur Polymerisation oder Härtung des säurepolymerisierbaren oder säurehärtbaren Materials befähigten Säure ableitendes Anion stehen, enthalten.

Geeignete säurepolymerisierbare oder säurehärtbare Materialien sind dabei Epoxide, Episulfide, Phenolharze, Aminoplaste und Poly-(N-methylol)-derivate von Polycarbonsäureamiden wie Polyacrylamid, und als Jodoniumsalze eignen sich unter anderem Diphenyljodonium-tetrafluoroborat, 4,4'-Dimethyldiphenyljodonium-hydrogensulfat und 4,4'-Dichlordiphenyljodonium-hexafluoroarsenat.

Weitere Patentschriften beschreiben die Photopolymerisation spezieller Materialtypen in Gegenwart eines Diaryljodoniumsalzes.

Beispielsweise ist in der britischen Patentschrift Nr. 1 565 671 und der entsprechenden U.S. Patentschrift Nr. 4 256 828 eine Zusammensetzung beschrieben, die aus einem Polyepoxid, einer organischen Hydroxylverbindung mit einer Hydroxylfunktionalität von 1 oder höher, wie einem Alkylenglykol, und als Photoinitiator einem Salz der Formel I besteht.

Aus der britischen Patentschrift Nr. 1 554 389 und der entsprechenden U.S. Patentschrift Nr. 4 193 799 sind photohärtbare Zusammensetzungen bekannt, die aus einem Epoxidharz, einem Polyvinylacetal und einem aromatischen Oniumsalz bestehen, wobei der letztere Begriff Diaryljodoniumsalze wie Diphenyljodonium-hexafluoroarsenat umfassen soll.

Die U.S. Patentschrift Nr. 4090936 beschreibt photohärtbare flüssige Zusammensetzungen, die aus einer Epoxidverbindung mit einer Durchschnittsepoxidfunktionalität von 1 bis 1,3, einem verträglichen Polymer mit einer Glasübergangstemperatur von 20 bis 105°C, nämlich einem Acrylat- oder Methacrylatpolymer, einem Styrol/Allylalkoholcopolymer oder Polyvinylbutyral, und als Photoinitiator einem aromatischen Komplexsalz bestehen, wobei letzterer Begriff die Diaryljodoniumsalze der Formel I umfassen soll.

Die U.S. Patentschrift Nr. 4310469 beschreibt lagerfähige, UV-härtbare Epoxi-silanzusammensetzungen, die als Photoinitiator ein Diaryljodoniumsalz der Formel

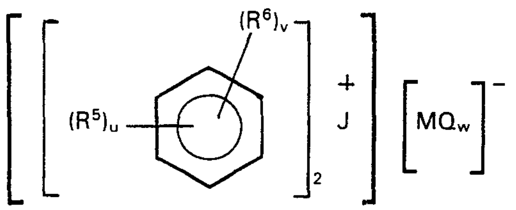 III

worin $R^5$ für eine Alkyl- oder Halogenalkylgruppe mit 4 bis 20 Kohlenstoffatomen, $R^6$ für eine Alkylgruppe mit 1 bis 3 Kohlenstoffatomen, eine Alkoxygruppe mit 1 bis 8 Kohlenstoffatomen, eine Nitrogruppe oder ein Halogenatom, M für ein Metall- oder Metalloidatom und Q für ein Halogenatom stehen, u 1 bis 4 und v null oder 1 bis 3 derart, dass (u + v) = 1 bis 4 und w 4 bis 6 sind, enthalten.

Aus der U.S. Patentschrift Nr. 4227978 sind photohärtbare Zusammensetzungen bekannt, die aus einem halogenierten oligomeren Ester, wie einem sich von Tetrachlorphthalsäureanhydrid und Äthylenglykol ableitenden Ester, einem Acrylat- oder Methacrylatmonomer, wie Butandiolacrylat, einem kationischen Initiator wie Diphenyljodonium-hexafluorophosphat, einer Epoxidverbindung und einem Radikalinitiator wie Diäthoxyacetophenon bestehen.

In der britischen Patentschrift Nr. 2073760 sind strahlungshärtbare Zusammensetzungen beschrieben, die ein Dihydropyran und als bei Belichtung mit Strahlung eine Säure freisetzenden Katalysator ein Aryljodonium-, Aryldiazonium- oder Arylsulfoniumsalz enthalten. Das einzige speziell erwähnte Aryljodoniumsalz ist ein Diaryljodoniumsalz, nämlich Diphenyljodonium-hexafluoroarsenat.

Schliesslich offenbart die U.S. Patentschrift Nr. 4108747 härtbare Zusammensetzungen, die aus einem kationisch polymerisierbaren Material, wie einem Gemisch aus einem Epoxid-novolak und 4-Vinylcyclohexendioxyd oder Diäthylenglykoldivinyläther zusammen mit einem strahlungsempfindlichen Sulfonat bestehen, wobei letzterer Begriff Jodoniumsulfonate der Formel

$$\left[R^7_p\ R^8_q\ \overset{+}{J}\right] \quad \left[X''\ SO_3^-\right] \qquad IV$$

worin $R^7$ für eine aromatische einwertige und $R^8$ für eine aromatische zweiwertige Gruppe stehen, p null oder 2 und q null oder 1 sind, derart, dass eines von p und q aber nicht beide null sind, und X'' eine aromatische Kohlenwasserstoffgruppe mit 6 bis 13 Kohlenstoffatomen, eine Alkyl- oder Halogenalkylgruppe mit 1 bis 8 Kohlenstoffatomen oder Fluor bedeutet, einschliesst.

In einer Artikelreihe von O.Y. Neiland u.a., wie Neiland und Karele, J. Org. Chem. USSR, 6.4, (April 1970), 889-890, Karele, Kalnin, Grinberga und Neiland, Chem. Heterocycl. Comp. (April 1973) 510-512 sowie Arena und Neiland, J. Org. Chem. USSR, 17 (1981) 1884-1887 sind Monoaryljodoniumsalze und deren Ylidvorstufen beschrieben. Keiner dieser Artikel gibt jedoch irgendeinen Hinweis auf das Verhalten der Monoaryljodoniumsalze, wenn sie aktinischer Strahlung ausgesetzt werden, oder eine mögliche Verwendung für diese.

Es wurde nun gefunden, dass Monoaryljodoniumsalze als Photoinitiatoren für kationisch polymerisierbare Materialien wirken. Keine der Veröffentlichungen des Standes der Technik legt es nahe, dass ein Monoaryljodoniumsalz diese wertvolle Eigenschaft besitzen würde. Ferner wurde gefunden, dass die Monoaryljodoniumsalze nicht nur als Photoinitiatoren wirken, wenn sie mit Licht ähnlicher Wellenlängen bestrahlt werden, wie denen, wo die Diaryljodoniumsalze aktiv sind, sondern auch bei Bestrahlung mit Licht längerer Wellenlängen, typischerweise 350-550 nm. Bei solchen Wellenlängen wirken die Diaryljodoniumsalze als Photoinitiatoren nur in Gegenwart geeigneter Cosensibilisatoren wie Acridingelb, Acridinorange, Phosphin R, Benzoflavin, Setoflavin T oder deren Gemischen.

Gegenstand dieser Erfindung sind dementsprechend photopolymerisierbare Zusammensetzungen enthaltend ein kationisch polymerisierbares Material und als Photoinitiator ein Monoaryljodoniumsalz der Formel V

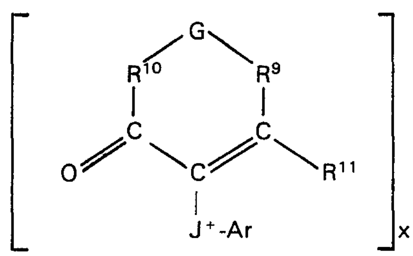 $Y^{x-}$ (V),

worin Ar eine gegebenenfalls substituierte Phenylgruppe bedeutet, $R^9$ und $R^{10}$, die gleich oder verschieden sein können, für Methylen-, Methin-, Oxy- oder Iminogruppen stehen, G eine kovalente Bindung oder eine Methylen-, Monoalkylmethylen-, Dialkylmethylen-, Methin-, Alkylmethin- oder Carbonylgruppe darstellt, wobei solche Alkylgruppen 1 bis 4 Kohlenstoffatome aufweisen, $R^{11}$ ein Wasserstoffatom, eine Hydroxylgruppe oder eine Alkyl- oder Alkoxygruppe mit 1 bis 4 Kohlenstoffatomen bedeutet, x 1, 2 oder 3 ist und $Y^{x-}$ ein von einer zur Polymerisation des kationisch polymerisierbaren Materials befähigten Säure abgeleitetes, x-wertiges Anion bedeutet.

Bei Belichtung dieser neuartigen Zusammensetzungen mit Strahlung geeigneter Wellenlänge tritt Polymerisation oder Vernetzung ein; es ist anzunehmen, dass dies durch Freisetzung einer Art saurer Verbindung aus dem Jodoniumsalz erfolgt. Gegenstand dieser Erfindung ist daher weiterhin ein Verfahren zur Herstellung polymeren oder vernetzten Materials, welches dadurch gekennzeichnet ist, dass man eine mindestens ein kationisch polymerisierbares Material und einen Photoinitiator der Formel V enthaltende photopolymerisierbare Zusammensetzung der Strahlung einer solchen Wellenlänge aussetzt, dass der Photoinitiator aktiviert und die Zusammensetzung polymerisiert oder vernetzt wird.

Bei der im erfindungsgemässen Verfahren verwendeten Strahlung kann es sich ausschliesslich um Ultraviolettstrahlung oder auch um Strahlung mit Wellenlängen sowohl im ultravioletten als auch im sichtbaren Spektralbereich handeln.

Die bevorzugte Wellenlänge der im erfindungsgemässen Verfahren angewandten Strahlung liegt im Bereich von 200 bis 600 nm, insbesondere 200 bis 450 nm.

Die Gruppen $R^9$, G und $R^{10}$ bilden vorzugsweise mit den angegebenen Kohlenstoffatomen einen Cyclohexenyl-, Tetrahydropyrimidinyl- oder Pyranylring. Die Gruppe $R^{11}$ ist vorzugsweise ein Wasserstoffatom, eine Hydroxylgruppe oder eine Methylgruppe. Die Gruppe Ar kann durch beispielsweise eine oder mehrere Alkyl- oder Alkoxygruppen mit 1 bis 4 Kohlenstoffatomen, eine oder mehrere Nitrogruppen oder ein oder mehrere Halogenatome substituiert sein, ist aber vorzugsweise unsubstituiert.

Geeignete Anionen $Y^{x-}$ leiten sich beispielsweise ab von organischen Carbonsäuren, wie Acetate und Trifluoracetate, von organischen Sulfonsäuren $R^{12}$-$SO_3H$, worin $R^{12}$ eine gegebenenfalls durch ein oder mehrere Halogenatome substituierte aliphatische, aromatische oder aliphatisch-substituierte aromatische Gruppe vorzugsweise mit 1 bis 20 Kohlenstoffatomen, bedeutet, wie Methansulfonate, Benzolsulfonate, Toluol-p-sulfonate und Trifluormethansulfonate, und von anorganischen Säuren, typischerweise Halogenide wie Fluoride, Chloride und Bromide, Halogenate wie Jodate, Perhalogenate wie Perchlorate, sowie Nitrate, Sulfate, Hydrogensulfate, Phosphate, Hydrogenphosphate, und komplexe Anionen, insbesondere Pentafluorohydroxoantimonate und Ionen der Formel $MQ_w^-$, worin M für ein Metall- oder Metalloidatom und Q für ein Halogenatom stehen und w eine ganze Zahl von 4 bis 6 und um eins grösser als die Wertigkeit von M ist.

Die Anionen der Formel $MQ_w$ sind vorzugsweise Polyhalogenide des Antimons, Arsens, Wismuts, Eisens, Zinns, Bors und Phosphors, wie Hexafluoroantimonat, Hexachloroantimonat, Hexafluoroarsenat, Pentachlorowismutat, Tetrachloroferrat, Hexachlorostannat, Tetrafluoroborat oder Hexafluorophosphat, wobei die beiden letztgenannten besonders bevorzugt sind.

Jedes kationisch polymerisierbare Material lässt sich durch Belichtung mit Strahlung in Gegenwart eines geeigneten Salzes der Formel V härten oder polymerisieren. Es wird jedoch nicht jedes solches Material durch alle solche Salze gehärtet, und die genaue Art des Materials und des Anions Y ist dabei kritisch und muss für wirksame Härtung entsprechend ausgewählt werden. Die Abstimmung eines kationisch polymerisierbaren Materials mit einem geeigneten Anion gehört durchaus zum Wissen des Fachmanns in der Härtung oder Polymerisation kationisch polymerisierbarer Zusammensetzungen. Beispielsweise sind sich von organischen Carbonsäuren, organischen Sulfonsäuren und anorganischen Säuren ableitende Anionen enthaltende Salze, insbesondere Acetate, Trifluoracetate, Methansulfonate, Benzolsulfonate, Toluol-p-sulfonate, Trifluormethansulfonate, Fluoride, Chloride, Bromide, Jodate, Perchlorate, Nitrate, Sulfate, Hydrogensulfate, Phosphate oder Hydrogenphosphate, zur Härtung von Phenoplasten wie Phenol/Formaldehydharzen und Aminoplasten wie Harnstoff/Formaldehyd- und Melamin/Formaldehydharzen befähigt. Ein Metall- oder Metalloidhalogenidanion enthaltende Salze können Epoxidharze oder Episulfidharze härten bzw. Mono-1,2-epoxide, Monoepisulfide oder Vinyläther polymerisieren. Weitere durch Bestrahlung in Gegenwart eines Jodoniumsalzes, wie in den bei der Würdigung des Standes der Technik hierin angeführten Patentschriften erwähnt, härtbare oder polymerisierbare Materialien lassen sich durch Bestrahlung in Gegenwart eines geeigneten Salzes der Formel V härten bzw. polymerisieren.

Als erfindungsgemäss verwendetes kationisch polymerisierbares Material kommen beispielsweise ein Oxetan, ein Thiiran oder ein Tetrahydrofuran in Betracht. Vorzugsweise handelt es sich um ein 1,2-Monoepoxid oder -episulfid mit 2 bis 20 Kohlenstoffatomen, wie Äthylenoxyd, Äthylensulfid, Propylenoxyd oder Propylensulfid, ein Epoxidharz, insbesondere einen Polyglycidyläther eines Bisphenols oder ein cycloaliphatisches Epoxidharz wie 3',4'-Epoxicyclohexancarbonsäure-3,4-epoxicyclohexylmethylester, ein Phenoplast, ein Aminoplast wie ein Harnstoff/Formaldehyd- oder Melamin/Formaldehydharz oder eine sonstige Methylolverbindung wie ein Poly-(N-methylol)-derivat eines Polycarbonsäureamids. Kationisch polymerisierbare, äthylenisch ungesättigte Materialien, wie Diketen, Vinyläther, Vinylcarbazol oder Styrol sind ebenfalls verwendbar.

Besonders bevorzugt wird die Verwendung eines 1,2-Monoepoxids oder eines Epoxidharzes mit einem wie oben definierten Jodoniumsalz mit einem Metall- oder Metalloidhalogenidanion, sowie die Verwendung eines Aminoplasts oder Phenoplasts mit einem wie oben definierten Jodoniumsalz mit einem Acetat-, Trifluoracetat-, Methansulfonat-, Benzolsulfonat-, Toluol-p-sulfonat-, Trifluormethansulfonat-, Fluorid-, Chlorid-, Bromid-, Jodat-, Perchlorat-, Nitrat-, Sulfat-, Hydrogensulfat-, Phosphat- oder hydrogenphosphatanion.

Wird ein Epoxidharz eingesetzt, so kann dieses zusammen mit einem mehrwertigen Alkohol, d.h. einer Verbindung mit mindestens zwei alkoholischen, vorzugsweise primären, Hydroxylgruppen pro Molekül gehärtet werden. Der Alkohol liegt vorzugsweise in einer solchen Menge vor, dass er 0,5 bis 1,5 alkoholische Hydroxylgruppen pro Epoxidgruppe im Harz liefert. Beispiele für geeignete mehrwertige Alkohole

sind Polyoxyalkylenglykole, Polyoxyalkylentriole, Polycaprolactone mit Hydroxylendgruppen, Styrolcopolymere mit Allylalkohol sowie Polyvinylalkohole.

Die in den Zusammensetzungen vorliegende Menge Salz der Formel V ist im allgemeinen nicht entscheidend, da nur katalytische Mengen erforderlich sind, um die Härtung oder Photopolymerisation in Gang zu bringen. Im allgemeinen setzt man dabei 0,01 bis 10 Gew.-% und vorzugsweise 0,5 bis 5 Gew.-%, bezogen auf das Gewicht des kationisch polymerisierbaren Materials, ein.

Zu weiteren Materialien, die in die erfindungsgemässen Zusammensetzungen eingearbeitet werden können, gehören Verdünnungsmittel, insbesondere flüssige Verdünnungsmittel, Füllstoffe wie Kieselsäure, Talkum, Glasmikroballons, Tone, gepulverte Metalle oder Zinkoxyd, Viskositätsregler wie Asbest, und Kautschuke, Klebrigmacher sowie Pigmente.

Die erfindungsgemässen Zusammensetzungen können ferner einen photochemischen Radikalbildner oder einen Photosensibilisator enthalten. Es wurde gefunden, dass man durch Einarbeitung geeigneter solcher Beschleuniger die Härtungsgeschwindigkeit weiter steigern und dadurch die Anwendung kürzerer Belichtungszeiten und/oder energieärmerer Strahlungsquellen ermöglichen kann. Aromatische Carbonylverbindungen sind als Radikalbildner besonders bevorzugt. Diese sind zwar schon zur Radikalpolymerisation äthylenisch ungesättigter Verbindungen verwendet worden, doch ist es überraschend, dass sie die kationische Polymerisation beschleunigen.

Die Zusammensetzungen können ferner Photosensibilisatoren enthalten, welche die Absorption der Zusammensetzungen über den bevorzugten Wellenlängenbereich hinaus ausdehnen, wie Polyarylene, (z.B. Perylen und 9,10-Diäthoxyanthracen), Polyarylpolyene, 2,5-Diarylisobenzofurane, 2,5-Diarylpyrrole, 2,5-Diarylcyclopentadiene, Polyarylphenylene, Cumarin und Polyaryl-2-pyrazoline.

Salze der Formel V lassen sich nach einer ähnlichen Methode wie von Karele, Kainin, Grinberga und Neiland beschrieben (a.a.O.) durch Umsetzung eines Phenyljodosotosylats mit einer cyclischen Verbindung der Formel

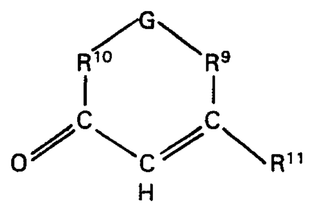

(VI),

worin G, $R^9$, $R^{10}$ und $R^{11}$ die oben angegebenen Bedeutungen haben, herstellen. Das entstandene Tosylatsalz lässt sich durch doppelte Umsetzung nach bekannten Methoden in andere Salze der Formel V umwandeln. Wenn $R^{11}$ in der Verbindung der Formel VI eine Alkoxygruppe darstellt, kann die Reaktion mit einem Phenyljodosotosylat zu Entalkylierung unter Bildung der Verbindung der Formel V, worin $R^{11}$ eine Hydroxylgruppe darstellt, führen.

Gewünschtenfalls kann man die erfindungsgemässen Zusammensetzungen durch Bestrahlung teilweise härten und die Härtung durch Erhitzen vervollständigen. Für ein solches zweistufiges Härtungsverfahren ist es erforderlich, dass das härtbare Material beim Erhitzen selbsthärtend ist, oder dass die Zusammensetzung einen hitzeaktivierbaren Härter für das härtbare Material enthält. Solche hitzeaktivierbare Härter sind bekannt, und es liegen im Rahmen der Fähigkeiten eines Fachmanns in Härtungsverfahren, einen für das jeweilige härtbare Material geeigneten Heisshärter auszuwählen. Unter diesen Umständen ist es natürlich wichtig, dass die Bestrahlung bei einer Temperatur unterhalb derjenigen ausgeführt wird, bei der eine wesentliche Heisshärtung des photopolymerisierten Produkts eintreten würde.

Die erfindungsgemässen Zusammensetzungen sind als Oberflächenbeschichtungen verwendbar. Sie lassen sich auf eine Unterlage wie Stahl, Aluminium, Kupfer, Cadmium, Zink, Papier oder Holz, vorzugsweise als Flüssigkeit, aufbringen und werden dann bestrahlt oder erhitzt. Durch teilweise Photopolymerisation der Beschichtung, wie mittels Bestrahlung durch eine Maske hindurch, können die unbelichteten Stellen zur Entfernung der nicht polymerisierten Anteile mit einem Lösungsmittel ausgewaschen werden, wobei die photopolymerisierten, unlöslichen Anteile an Ort und Stelle bleiben. Die erfindungsgemässen Zusammensetzungen lassen sich somit zur Herstellung von Druckplatten und gedruckten Schaltungen verwenden. Methoden zur Herstellung von Druckplatten und gedruckten Schaltungen aus photopolymerisierbaren Zusammensetzungen sind wohlbekannt.

Die Zusammensetzungen sind auch als Klebstoffe einsetzbar. Eine Schicht der Zusammensetzung kann zwischen zwei Oberflächen von Gegenständen eingebracht werden, der Aufbau wird dann bestrahlt und gewünschtenfalls erhitzt, um die Polymerisation zu Ende zu führen. Dabei ist es natürlich erforderlich, dass mindestens einer der Gegenstände für aktinische Strahlung durchlässig ist, z.B. aus Glas besteht.

Die Zusammensetzungen sind auch bei der Herstellung von faserverstärkten Verbundstoffen, einschliesslich vorgemischten Formmassen nützlich.

Sie können direkt und kontinuierlich oder diskontinuierlich in flüssiger Form auf Verstärkungsfasern (einschliesslich Spinnfäden, Filamente und Whiskers) aufgebracht werden, die als Gewebe oder Vlies, unidirektionelle Längen oder geschnittene Spinnfäden, insbesondere aus Glas, Bor, Edelstahl, Wolfram, Tonerde, Siliciumcarbid, Asbest oder Kaliumtitanwhiskers, einem aromatischen Polyamid wie Poly-(m-phenylenisophthalamid), Poly-(p-phenylenterephthalamid) oder Poly-(p-benzamid), Polyäthylen, Polypropylen oder Kohlenstoff, vorliegen können.

Der faserverstärkte Verbundstoff kann auch nach einem Chargenverfahren oder kontinuierlich aus Folien der photopolymerisierten Zusammensetzung hergestellt werden. Beim chargenweisen Verfahren wird das faserige Verstärkungsmaterial auf eine zweckmässig unter einer geringen Spannung stehende Folie aus der photopolymerisierten Zusammensetzung aufgelegt, gegebenenfalls wird eine zweite solche Folie darüber gelegt, und der Aufbau wird dann unter Erhitzen verpresst. Der Verbundstoff lässt sich auch kontinuierlich herstellen, z.B. indem man das faserige Verstärkungsmaterial mit einer Folie der photopolymerisierten Zusammensetzung in Berührung bringt, dann gewünschtenfalls eine zweite solche Folie auf die Rückseite des faserigen Verstärkungsmaterials legt und Hitze und Druck einwirken lässt. Einfacher ist es, zwei solche, vorzugsweise auf der Rückseite durch Bänder oder abziehbare Bögen abgestützte Folien gleichzeitig so auf das faserige Verstärkungsmaterial aufzubringen, dass es mit jeder belichteten Fläche in Berührung kommt. Bei Aufbringung zweier solcher Folien können diese gleich oder verschieden sein.

Mehrschichtige Verbundkörper lassen sich durch Druckerhitzung zwischengeordneter Folien und Schichten aus einem oder mehreren faserigen Verstärkungsmaterialien herstellen. Bei Verwendung unidirektioneller Fasern als Verstärkungsmaterial können aufeinanderfolgende Schichten von diesen so orientiert werden, dass sie verkreuzte Schichtstrukturen ergeben.

Mit dem faserigen Verstärkungsmaterial kann man zusätzliche Verstärkungstypen wie eine Metallfolie (z.B. Aluminium, Stahl oder Titan) oder eine Folie aus Kunststoff (z.B. einem aromatischen oder aliphatischen Polyamid, einem Polyimid, einem Polysulfon oder Polycarbonat) oder einem Kautschuk (z.B. einem Neopren- oder Acrylnitrilkautschuk) mitverwenden.

Bei der Herstellung von vorgemischten Formmassen wird eine erfindungsgemässe Zusammensetzung zusammen mit dem Verstärkungsmaterial aus geschnittenen Fasern und weiteren Komponenten der Bestrahlung in Schichten durch Stützbögen hindurch ausgesetzt.

Die polymerisierbare Zusammensetzung wird dabei vorzugsweise so ausgetragen, dass der Verbundstoff insgesamt 20 bis 80 Gew.-% dieser Zusammensetzung sowie entsprechend 80 bis 20 Gew.-% Verstärkung enthält. Besonders bevorzugt werden insgesamt 30 bis 50 Gew.-% der Zusammensetzung eingesetzt.

Die erfindungsgemässen Zusammensetzungen sind zur Herstellung von Kitten und Füllstoffen verwendbar. Man kann sie für Tauchbeschichtungen einsetzen, wobei ein zu beschichtender Gegenstand in die flüssige Zusammensetzung eingetaucht, herausgenommen und die anhaftende Beschichtung dann zur Photopolymerisation (und somit Verfestigung) bestrahlt und danach gegebenenfalls erhitzt wird.

Es wurde gefunden, dass es bei Verwendung von Monoaryljodoniumsalzen der Formel V möglich ist, Epoxidharze oder Phenoplaste enthaltende Zusammensetzungen in zwei Stufen zu härten. Ist das Phenoplast ein Novolak, der unter der Einwirkung des Jodoniumsalzes nicht polymerisierbar ist, so wird dieser zusammen mit einem so polymerisierbaren Material, wie einem Epoxidharz oder Vinyläther, verwendet. Die Zusammensetzung wird zunächst durch Belichtung mit aktinischer Strahlung in Gegenwart eines solchen Salzes der Formel V und eines latenten, hitzeaktivierbaren Vernetzungsmittels für das Epoxidharz oder Phenoplast (wahlweise, falls das Phenoplast ein Resol ist) in die teilweise gehärtete B-Stufe überführt, und in einem zweiten Schritt wird die teilweise gehärtete Zusammensetzung so erhitzt, dass die Härtung vervollständigt wird. Somit kann man eine flüssige oder halbflüssige Zusammensetzung herstellen, die sich dann verformen oder zum Tränken eines Substrats mit gleichzeitiger Bestrahlung zu dessen Verfestigung verwenden lässt; der verfestigte Körper wird dann gewünschtenfalls erhitzt, um die Härtung des Harzes zu vervollständigen.

Gemäss einer weiteren Ausführungsform dieser Erfindung wird daher eine wie oben beschriebene, ein Epoxidharz oder ein Phenoplast enthaltende Zusammensetzung zusammen mit einer härtenden Menge eines latenten Heisshärters für das Epoxidharz oder Phenoplast zwecks Polymerisation bestrahlt und das bestrahlte Produkt zur gegebenen Zeit zur Härtung des Epoxidharzes oder Phenoplasts erhitzt.

Eine weitere Ausführungsform umfasst eine wie oben beschriebene, ein Epoxidharz oder Phenoplast sowie eine härtende Menge eines latenten Heisshärters für das Epoxidharz oder Phenoplast enthaltende Zusammensetzung.

Zu geeigneten hitzeaktivierbaren Vernetzungsmitteln für Epoxidharze zählen Polycarbonsäureanhydride, Komplexe von Aminen, insbesonders primären oder tertiären aliphatischen Aminen wie Äthylamin, Trimethylamin und n-Octyldimethylamin, mit Bortrifluorid oder Bortrichlorid sowie latente Bordifluoridchelate. Aromatische Polyamine und Imidazole sind im allgemeinen nicht vorzuziehen, da man mässige Ergebnisse erzielt, möglicherweise wegen einer Reaktion zwischen dem freigesetzten sauren Katalysator und dem Amin. Dicyandiamid lässt sich erfolgreich einsetzen, vorausgesetzt, dass es in verhältnismässig groben Teilchen vorliegt.

Als hitzeaktivierbare Vernetzungsmittel für Novolake eignen sich unter anderem Hexamethylentetramin und Paraformaldehyd.

Die zur Heisshärtung nach der Photopolymerisation erforderliche Temperatur und Erhitzungsdauer sowie die Anteile an hitzeaktivierbarem Härter lassen sich leicht durch Serienversuche ermitteln oder aus dem bereits wohlbekannten Fachwissen über die Heisshärtung von Epoxidharzen und Phenol/Aldehydharzen herleiten.

Zusammensetzungen, die Harze mit Epoxidgruppen oder phenolischen Hydroxylgruppen, über die sie nach der Photopolymerisation heissgehärtet werden können, enthalten, sind besonders nützlich bei der Herstellung von mehrschichtigen gedruckten Schaltungen.

Herkömmlicherweise wird eine mehrschichtige gedruckte Schaltung aus mehreren zweiseitig bedruckten Leiterplatten aus Kupfer hergestellt, die übereinandergestapelt und voneinander durch isolierende Folien, üblicherweise aus mit einem Epoxidharz oder Phenol/Formaldehydharz in der B-Stufe imprägnierten Glasfasern, getrennt sind. Wird kein Heisshärter in die photopolymerisierbare Harzschicht in der Leiterplatte eingemischt, so kann dieser in die mit den Platten abwechselnden Isolierschichten eingearbeitet werden, die herkömmlicherweise aus einem Epoxidharz- oder Phenol/Formaldehydharzpräpreg bestehen; vorausgesetzt, dass der Präpreg nicht zu dick ist, wandert genügend darin enthaltener Heisshärter aus, um die Vernetzung des photopolymerisierten Epoxidharzes oder Phenol/Formaldehydharzes einzuleiten. Der Stapel wird erhitzt und zur Bindung der Schichten verpresst. Herkömmliche photopolymerisierbare Materialien bilden jedoch keine starken Bindungen mit Kupfer oder harzimprägnierten Glasfaserbögen. Ein das Kupfer noch bedeckender mit dem Photopolymer gebundener Stapel ist deshalb an sich schwach und kann im Gebrauch auseinanderblättern. Es ist deshalb normale Praxis, nach der Ätzstufe das restliche Photopolymer entweder durch starke Lösungsmittel oder eine mechanische Methode, z.B. Bürsten, zu entfernen. Solch ein Abstreifverfahren kann das Kupfer der gedruckten Schaltung oder die Oberfläche des Schichtkörpers, auf dem diese aufliegt, beschädigen, und es besteht daher ein Bedarf nach einer Methode, die die Notwendigkeit einer Entfernung des photopolymerisierten Materials vor dem Verpressen der Platte vermeiden würde. Die Gegenwart restlicher Vernetzungsgruppen in den erfindungsgemässen Zusammensetzungen bedeutet, dass beim Verpressen der Platten Vernetzung eintreten kann, was eine gute Haftung am Kupfer und am harzimprägnierten Glasfasersubstrat ergibt, wodurch die eben erwähnte Notwendigkeit entfällt; ferner erhält man Produkte mit einem höheren Glasübergangspunkt.

Eine weitere Anwendung, bei der es sich um Heisshärtung nach der Photopolymerisation der erfindungsgemässen Zusammensetzungen handelt, besteht beim Wickelverfahren. Dabei wird ein endloses Kabel faseriger Verstärkung mit einer einen latenten Heisshärter enthaltenden Zusammensetzung imprägniert und dann unter Belichtung der Wicklung mit aktinischer Strahlung auf einen Dorn oder Kern aufgewickelt. Solche Fadenwickel besitzen immer noch einen gewissen Grad an Biegsamkeit, so dass sich der Dorn oder Kern leichter entfernen lässt, als wenn eine starre Wicklung in einer Stufe gebildet wird. Erforderlichenfalls wird die Wicklung zur Vernetzung der Zusammensetzung erhitzt.

Bei einer weiteren solchen Anwendung wird eine Schicht der Zusammensetzung in flüssiger Form bestrahlt, bis sie sich unter Bildung eines Klebfilms verfestigt, der dann zwischen zwei zu verklebende Oberflächen und in Berührung mit diesen eingelegt wird, und der Aufbau wird dann erhitzt, um die Vernetzung der Zusammensetzung zu vervollständigen. Der Film kann dabei auf einer Seite mit einer abziehbaren Schutzfolie, z.B. aus einem Polyolefin oder Polyester oder aus cellulosehaltigem Papier mit einer Silicontrennmittelbeschichtung, versehen sein. Der Aufbau ist häufig leichter zu handhaben, wenn der Film eine klebrige Oberfläche besitzt. Dies lässt sich dadurch erreichen, dass man den Film mit einer Substanz beschichtet, die bei Raumtemperatur klebrig ist, aber unter den zur Vervollständigung der Vernetzung der Zusammensetzung angewandten Bedingungen zu einem harten, unlöslichen, unschmelzbaren Harz vernetzt. Ein hinreichendes Mass Klebrigkeit besteht jedoch häufig ohne zusätzliche Behandlung, insbesondere wenn die Polymerisation der Zusammensetzung nicht zu weit fortgeschritten ist. Geeignete Klebsubstrate sind unter anderem Metalle wie Eisen, Zink, Kupfer, Nickel und Aluminium, Keramik, Glas und Kautschuke.

Die nachfolgenden Beispiele erläutern die Erfindung. Teile sind dabei stets Gewichtsteile.

Die in diesen Beispielen verwendeten Jodoniumsalze werden wie folgt hergestellt:

*Herstellungsbeispiel 1*

*Phenyl-(4,4-dimethyl-2-hydroxy-6-oxo-1-cyclohexenyl)-jodoniumtosylat*

(V; Ar = Phenyl; $R^9 = R^{10}$ = Methylen; $R^{11}$ = Hydroxy; G = Dimethylmethylen; $Y^{x-}$ = Tosylat)

Man vermischt äquimolare Mengen 5,5-Dimethyl-3-äthoxy-cyclohex-2-en-1-on und Phenyljodosotosylat (nach O. Ya Neiland und B. Ya Karele, J. Org. Chem. USSR, 6, 889-890 [1970] hergestellt) bei Raumtemperatur in Chloroform. Nach 45 Minuten wird das Produkt durch Zusatz von überschüssigem Petroläther (Siedebereich 60-80°C) ausgefällt. Dieses Produkt löst man in einem Minimum Chloroform wieder auf und fällt es erneut mit Petroläther, was die obige Verbindung als weissen kristallinen Feststoff vom Schmelzpunkt 110-112°C in 56% Ausbeute ergibt.

Die spektroskopische Analyse gibt die folgenden Resultate:

Infrarot (KBr-Scheibe) $\nu_{max}$ bei 3480, 2960, 1600, 1550, 1470, 1440, 1345, 1300, 1010, 990 und 735 $cm^{-1}$.

$^1$H-NMR ($CDCl_3$) δ bei 9,3 (1H, breites Singulett); 7-8 (9H, Multiplett); 2,65 (4H, Singulett); 2,3 (3H, Singulett); 0,95 (6H, Singulett).

*Herstellungsbeispiel 2*

*Phenyl-(4,4-dimethyl-2-hydroxy-6-oxo-1-cyclohexenyl)-jodonium-hexafluorophosphat*

(V; Ar = Phenyl; $R^9 = R^{10}$ = Methylen; $R^{11}$ = Hydroxy; G = Dimethylmethylen; $Y^{x-}$ = Hexafluorophosphat)

Man löst das oben hergestellte Tosylat in Wasser und versetzt mit wässriger Kaliumhexafluorophosphatlösung in geringem Überschuss. Es bildet sich ein Niederschlag, und dieser wird abfiltriert und getrocknet. Die infrarotspektroskopische Analyse zeigt eine Bande bei 845 $cm^{-1}$, was mit dem Hexafluorophosphatanion im Einklang steht.

*Herstellungsbeispiel 3*

*Phenyl-(2,4-dioxo-1,2,3,4-tetrahydropyrimidin-5-yl)-jodoniumtosylat*

(V; Ar = Phenyl; $R^9 = R^{10}$ = Imino; $R^{11}$ = H; G = Carbonyl; $Y^{x-}$ = Tosylat)

Man verfährt wie in Herstellungsbeispiel 1 unter Ersatz des Cyclohexenons durch eine äquimolare Menge Uracil. Nach Entfernung einer geringen Menge unlöslichen Materials durch Filtrieren wird das Produkt durch Eindampfen des Chloroforms isoliert.

Die Produktausbeute beträgt 62%, und der Schmelzpunkt 120-122°C. Die Infrarotanalyse (KBr-Scheibe) zeigt $v_{max}$ bei 3450, 1180, 1130, 1040, 1015, 815 und 700 $cm^{-1}$.

*Herstellungsbeispiel 4*

*Phenyl-(2,4-dioxo-6-hydroxy-1,2,3,4-tetrahydro-pyrimidin-5-yl)-jodoniumtosylat*
(V; Ar = Phenyl; $R^9 = R^{10}$ = Imino; $R^{11}$ = OH; G = Carbonyl; $Y^{x-}$ = Tosylat)

Man verfährt wie in Herstellungsbeispiel 1, unter Ersatz des Cyclohexenons durch eine äquimolare Menge Barbitursäure. Man erhält 30% Ausbeute an Produkt. Die Infrarotanalyse (KBr-Scheibe) zeigt $v_{max}$ bei 3500, 3280, 3040, 1710, 1610, 1495, 1360 und 1260 $cm^{-1}$.

*Herstellungsbeispiel 5*

*Phenyl-(2,6-dimethyl-4-oxo-4H-pyran-3-yl)-jodoniumtosylat*
(V; Ar = Phenyl; $R^9$ = Oxy; $R^{10}$ = Methin; $R^{11}$ = Methyl; G = Methylmethin; $Y^{x-}$ = Tosylat)

Man verfährt wie in Herstellungsbeispiel 1, unter Ersatz des Cyclohexenons durch eine äquimolare Menge 2,6-Dimethyl-γ-pyron. Man erhält 20% Ausbeute an bei 98-100°C schmelzendem Produkt. Die spektroskopische Analyse des Produkts zeigt folgendes:

Infrarot (KBr-Scheibe) $v_{max}$ bei 1670, 1185, 1130, 1045, 1015, 820 und 700 $cm^{-1}$.

$^1$H-NMR (perdeuteriertes Aceton) δ bei 9,0 (1H, breites Singulett); 7-8 (9H, Multiplett); 2,5 (6H, Singulett); 2,35 (3H, Singulett).

*Herstellungsbeispiel 6*

*Phenyl-(2,4-dioxo-6-hydroxy-1,2,3,4-tetrahydro-pyrimidin-5-yl)-jodoniumhexafluorophosphat*
(V; Ar = Phenyl; $R^9 = R^{10}$ = Imino; $R^{11}$ = OH; G = Carbonyl; $Y^{x-}$ = Hexafluorophosphat)

Man löst das Tosylat aus Herstellungsbeispiel 4 in Wasser und verrührt mit einem geringen Überschuss Kaliumhexafluorophosphat in wässriger Lösung. Das gewünschte Salz fällt aus der Lösung aus, und die Gegenwart von Hexafluorophosphatanion wird durch das Vorhandensein einer Bande bei 850 $cm^{-1}$ im Infrarotspektrum des Produkts bestätigt.

*Herstellungsbeispiel 7*

*Phenyl-(2-hydroxy-6-oxo-1-cyclohexenyl)-jodoniumhexafluorophosphat*
(V; Ar = Phenyl; $R^9 = R^{10}$ = G = Methylen; $R^{11}$ = Hydroxy; $Y^{x-}$ = Hexafluorophosphat)

Man verfährt wie in Herstellungsbeispiel 1, unter Ersatz des dort verwendeten Cyclohexenons durch eine äquimolare Menge 3-Äthoxycyclohex-2-en-1-on. Dabei erhält man in 60% Ausbeute das Tosylat des obigen Jodoniumkations mit der folgenden spektroskopischen Analyse:

Infrarot (KBr-Scheibe) $v_{max}$ bei 3450, 1730, 1530, 1360, 1010 und 750 $cm^{-1}$.

$^1$H-NMR ($CDCl_3$) δ bei 9,3 (1H, breites Singulett); 7-8 (9H, Multiplett); 2,5 (4H, Multiplett); 2,35 (3H, Singulett); 2,3 (2H, Multiplett).

Man löst das Tosylat in Wasser und versetzt mit einem geringen Überschuss Kaliumhexafluorophosphat in wässriger Lösung. Das gewünschte Hexafluorophosphat fällt aus der Lösung aus. Die Gegenwart von Hexafluorophosphatanion wird durch das Vorhandensein einer Bande bei 850 $cm^{-1}$ im Infrarotspektrum bestätigt.

Die bei diesen Beispielen verwendeten Harze sind wie folgt:

*Harz I*

Harz I ist ein Phenol/Formaldehydharz mit einem P:F-Verhältnis von 1:1,14, einer Viskosität von 0,7 Pas bei 25°C und 76% Feststoffgehalt, mit 4-Toluolsulfonsäure neutralisiert.

*Harz II*

Harz II bezeichnet den Diglycidyläther des 2,2-Bis-(4-hydroxyphenyl)-propans.

*Harz III*

Harz III ist 3,4-Epoxicyclohexancarbonsäure-3,4-epoxicyclohexylmethylester.

*Beispiel 1*

Man beschichtet Weissblech mit einem Gemisch aus Harz I (100 Teile) und Phenyl-(4,4-dimethyl-2-hydroxy-6-oxo-1-cyclohexenyl)-jodoniumtosylat (3 Teile) zu einer 8 µm dicken Schicht. 10 Sekunden Bestrahlung mit einer 80 W/cm Mitteldruckquecksilberlampe in 20 cm Abstand ergibt eine klebfreie Beschichtung.

*Beispiel 2*

Man beschichtet Weissblech mit einem Gemisch aus Harz II (100 Teile) und Phenyl-(4,4-dimethyl-2-hydroxy-6-oxo-1-cyclohexenyl)-jodoniumhexafluorophosphat (3 Teile) in des Films 6-8 µm Dicke. 5 Sekunden Bestrahlung mit einer 80 W/cm Mitteldruckquecksilberlampe in 20 cm Abstand ergibt eine klebfreie Beschichtung.

*Beispiel 3*

Man beschichtet Weissblech mit einem Gemisch aus Harz I (100 Teile) und Phenyl-(2,4-dioxo-1,2,3,4-tetrahydropyrimidin-5-yl)-jodoniumtosylat (3 Teile) zu ungefähr 8 µm Dicke. Die Beschichtung wird 10 Sekunden mit einer 80 W/cm Mitteldruckquecksilberlampe in 20 cm Abstand bestrahlt, was eine klebfreie Beschichtung liefert.

*Beispiel 4*

Man beschichtet Weissblech mit einem Gemisch aus Harz I (100 Teile) und Phenyl-(2,6-dimethyl-4-oxo-4H-pyran-3-yl)-jodoniumtosylat (3 Teile) zu 6-8 µm Dicke. 10 Sekunden Bestrahlung des Films mit einer 80 W/cm Mitteldruckquecksilberlampe in 20 cm Abstand ergibt eine klebfreie Beschichtung.

*Beispiel 5*

Man streicht ein Gemisch aus Harz I (100 Teile) und Phenyl-(2,4-dioxo-6-hydroxy-1,2,3,4-tetrahydropyrimidin-5-yl)-jodoniumtosylat (3 Teile) in 8 µm

Dicke auf Weissblech. 10 Sekunden Bestrahlung des Films mit einer 80 W/cm Mitteldruckquecksilberlampe in 20 cm Abstand ergibt eine klebfreie Beschichtung.

*Beispiel 6*

Man beschichtet Weissblech mit einem Gemisch aus Harz II (100 Teile) und Phenyl-(2,4-dioxo-6-hydroxy-1,2,3,4-tetrahydropyrimidin-5-yl)-jodoniumhexafluorophosphat (3 Teile) zu ungefähr 8 µm Dicke. 10 Sekunden Bestrahlung der Beschichtung mit einer 80 W/cm Mitteldruckquecksilberlampe in 20 cm Abstand ergibt einen klebfreien Überzug.

*Beispiel 7*

Man beschichtet Weissblech mit einem Gemisch aus Harz II (100 Teile), Harz III (20 Teile) und Phenyl-(2-hydroxy-6-oxo-1-cyclohexenyl)-jodoniumhexafluorophosphat (3 Teile) in 8 µm Dicke. Die Beschichtung wird 5 Sekunden mit einer 80 W/cm Mitteldruckquecksilberlampe in 20 cm Abstand bestrahlt, was eine klebfreie Beschichtung liefert.

*Beispiel 8*

Man beschichtet Weissblech mit einem Gemisch aus Harz II (100 Teile) und Phenyl-(4,4-dimethyl-2-hydroxy-6-oxo-1-cyclohexenyl)-jodoniumhexafluorophosphat (3 Teile) zu 6-8 Mikrometer Dicke. 20 Sekunden Bestrahlung des Films mit einer 5000 W Metallhalogenidlampe, deren Hauptausstrahlung bei 365 nm und 420 nm liegt, in 75 cm Abstand ergibt eine klebfreie Beschichtung.

**Patentansprüche**

1. Photopolymerisierbare Zusammensetzungen enthaltend ein kationisch polymerisierbares Material und als Photoinitiator ein Monoaryljodoniumsalz der Formel V

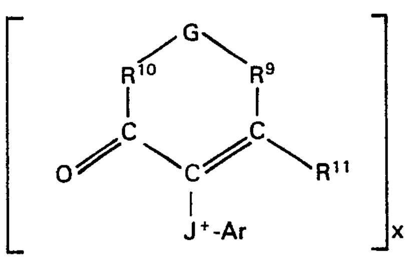

$Y^{x-}$ (V),

worin Ar eine gegebenenfalls substituierte Phenylgruppe bedeutet, $R^9$ und $R^{10}$, die gleich oder verschieden sein können, für Methylen-, Methin-, Oxy- oder Iminogruppen stehen, G eine kovalente Bindung oder eine Methylen-, Monoalkylmethylen-, Dialkylmethylen-, Methin-, Alkylmethin- oder Carbonylgruppe darstellt, wobei solche Alkylgruppen 1 bis 4 Kohlenstoffatome aufweisen, $R^{11}$ ein Wasserstoffatom, eine Hydroxylgruppe oder eine Alkyl- oder Alkoxygruppe mit 1 bis 4 Kohlenstoffatomen bedeutet, x 1, 2 oder 3 ist und $Y^{x-}$ ein von einer zur Polymerisation des kationisch polymerisierbaren Materials befähigten Säure abgeleitetes x-wertiges Anion bedeutet.

2. Zusammensetzungen nach Anspruch 1, worin $R^9$, G und $R^{10}$ mit den angegebenen Kohlenstoffatomen einen Cyclohexenyl-, Tetrahydropyrimidinyl- oder Pyranylring bilden.

3. Zusammensetzungen nach Anspruch 1 oder 2, worin $R^{11}$ für ein Wasserstoffatom, eine Hydroxylgruppe oder eine Methylgruppe steht.

4. Zusammensetzungen nach einem der Ansprüchen 1 bis 3, worin Ar für eine unsubstituierte Phenylgruppe steht.

5. Zusammensetzungen nach einem der Ansprüche 1 bis 4, worin sich das Anion $Y^{x-}$ von einer organischen Carbonsäure, einer organischen Sulfonsäure $R^{12}SO_3H$, worin $R^{12}$ eine gegebenenfalls durch ein oder mehrere Halogenatome substituierte aliphatische, aromatische oder aliphatisch-substituierte aromatische Gruppe bedeutet, oder einer anorganischen Säure ableitet.

6. Zusammensetzungen nach Anspruch 5, worin als Anion $Y^{x-}$ ein Acetat, Trifluoracetat, Methansulfonat, Benzolsulfonat, Toluol-p-sulfonat, Trifluormethansulfonat, Fluorid, Chlorid, Bromid, Jodat, Perchlorat, Nitrat, Sulfat, Hydrogensulfat, Phosphat, Hydrogenphosphat oder Pentafluorohydroxoantimonat oder auch ein Anion der Formel $MQ_w^-$, worin M für ein Metall- oder Metalloidatom und Q für ein Halogenatom stehen und w eine ganze Zahl von 4 bis 6 und um eins grösser als die Wertigkeit von M ist, vorliegt.

7. Zusammensetzungen nach Anspruch 6, worin als Anion $Y^{x-}$ ein Hexafluoroantimonat, Hexachloroantimonat, Hexafluoroarsenat, Pentachlorowismutat, Tetrachloroferrat, Hexachlorostannat, Tetrafluoroborat oder Hexafluorophosphat vorliegt.

8. Zusammensetzungen nach einem der Ansprüche 1 bis 7, worin als kationisch polymerisierbares Material ein 1,2-Monoepoxid oder ein Epoxidharz vorliegt und das Jodoniumsalz ein Metallhalogenid- oder Metalloidhalogenidanion besitzt.

9. Zusammensetzungen nach einem der Ansprüche 1 bis 6, worin als kationisch polymerisierbares Material ein Aminoplast oder Phenoplast und als Jodoniumsalz ein Acetat, Trifluoracetat, Methansulfonat, Benzolsulfonat, Toluol-p-sulfonat, Trifluormethansulfonat, Fluorid, Chlorid, Bromid, Jodat, Perchlorat, Nitrat, Sulfat, Hydrogensulfat, Phosphat oder Hydrogenphosphat vorliegt.

10. Zusammensetzungen nach einem der Ansprüche 1 bis 9, enthaltend ein Epoxidharz oder Phenoplast und eine härtende Menge eines latenten Heisshärters für das Epoxidharz oder Phenoplast.

11. Verfahren zur Herstellung polymeren oder vernetzten Materials, dadurch gekennzeichnet, dass man eine Zusammensetzung nach einem der vorhergehenden Ansprüche der Strahlung einer solchen Wellenlänge aussetzt, dass Polymerisation oder Vernetzung der Zusammensetzung eintritt.

12. Verfahren nach Anspruch 11, dadurch gekennzeichnet, dass die Zusammensetzung eine solche nach Anspruch 10 ist und das bestrahlte Produkt zur Härtung des Epoxidharzes oder Phenoplasts erhitzt wird.

13. Verwendung der Zusammensetzungen gemäss Anspruch 1 als Oberflächenbeschichtungen, bei der Herstellung von Druckplatten und gedruckten Schaltungen und als Klebstoffe.

**Claims**

1. A photopolymerisable composition containing a cationically polymerisable material and, as photoinitiator, a monoaryl iodonium salt of formula

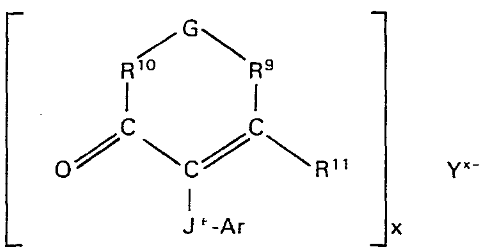

(V)

wherein Ar is an unsubstituted or substituted phenyl group, $R^9$ and $R^{10}$, which may be the same or different, are methylene, methine, oxy or imino groups, G is a covalent bond, or a methylene, monoalkylmethylene, dialkylmethylene, methine, alkylmethine, or carbonyl group, the said alkyl groups having from 1 to 4 carbon atoms, $R^{11}$ is a hydrogen atom, a hydroxyl group, or an alkyl or alkoxy group having from 1 to 4 carbon atoms, x is 1, 2, or 3, and $Y^{x-}$ is an x-valent anion derived from an acid which is capable of polymerising the cationically polymerisable material.

2. A composition according to claim 1, in which $R^9$, G and $R^{10}$, with the indicated carbon atoms, form a cyclohexenyl, tetrahydropyrimidinyl or pyranyl ring.

3. A composition according to either of claims 1 or 2, in which $R^{11}$ is a hydrogen atom, a hydroxyl group or a methyl group.

4. A composition according to any one of claims 1 to 3, in which Ar is an unsubstituted phenyl group.

5. A composition according to any one of claims 1 to 4, in which the anion $Y^{x-}$ is derived from an organic carboxylic acid, an organic sulphonic acid $R^{12}SO_3H$, where $R^{12}$ is an aliphatic, aromatic or aliphatic-substituted aromatic group, any of which may be substituted by one or more halogen atoms, or an inorganic acid.

6. A composition according to claim 5, in which the anion $Y^{x-}$ is an acetate, trifluoroacetate, methanesulphonate, benzenesulphonate, toluene-p--sulphonate, trifluoromethanesulphonate, fluoride, chloride, bromide, iodate, perchlorate, nitrate, sulphate, hydrogen sulphate, phosphate, hydrogen phosphate or pentafluorohydroxoantimonate or is an anion of formula $MQ_w^-$, where M is an atom of a metal or metalloid, Q is a halogen atom, and w is an integer of from 4 to 6 and is one more than the valency of M.

7. A composition according to claim 6, in which the anion $Y^{x-}$ is a hexafluoroantimonate, hexachloroantimonate, hexafluoroarsenate, pentachlorobismuthate, tetrachloroferrate, hexachloroferrate, hexachlorostannate, tetrafluoroborate, or hexafluorophosphate.

8. A composition according to any one of claims 1 to 7, in which the cationically polymerisable material is a 1,2-monoepoxide or an epoxide resin and the iodonium salt has a metal halide or metalloid halide anion.

9. A composition according to any one of claims 1 to 6, in which the cationically polymerisable material is an aminoplast or a phenoplast and the iodonium salt is an acetate, trifluoroacetate, methanesulphonate, benzenesulphonate, toluene-p--sulphonate, trifluoromethanesulphonate, fluoride, chloride, bromide, iodate, perchlorate, nitrate, sulphate, hydrogen sulphate, phosphate or hydrogen phosphate.

10. A composition according to any one of claims 1 to 9, which contains an epoxide resin or a phenoplast and a curing amount of a latent heat-curing agent for the epoxide resin or phenoplast.

11. A process for the preparation of polymeric or crosslinked material, which process comprises subjecting a composition as claimed in any one of the preceding claims to radiation of wavelength such as to effect polymerisation or crosslinking of the composition.

12. A process according to claim 11, in which the composition is as claimed in claim 10 and the irradiated product is heated to cure the epoxide resin or the phenoplast.

13. Use of a composition as claimed in claim 1 as a surface coating composition, in the preparation of printing plates and printed circuits, and as an adhesive.

**Revendications**

1. Compositions photopolymérisables qui contiennent une matière polymérisable cationiquement et, comme photo-amorceur, un sel de monoaryliodonium répondant à la formule V:

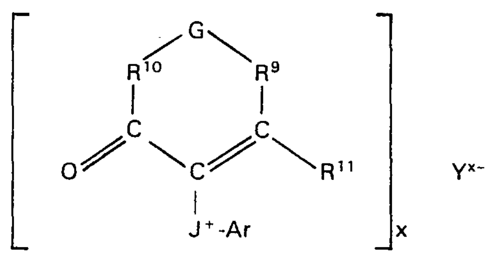

(V),

dans laquelle:

Ar représente un radical phényle éventuellement substitué,

$R^9$ et $R^{10}$ représentent chacun, indépendamment l'un de l'autre, un radical méthylène, méthine, oxy ou imino,

G représente une liaison covalente ou un radical méthylène, monoalkyl-méthylène, dialkyl-méthylène, méthine, alkyl-méthine ou carbonyle, ces radicaux alkyles contenant chacun de 1 à 4 atomes de carbone,

$R^{11}$ représente un atome d'hydrogène, un radical hydroxy ou un radical alkyle ou alcoxy contenant de 1 à 4 atomes de carbone,

x est un nombre égal à 1, 2 ou à 3 et

$Y^{x-}$ représente un anion de valence x qui dérive d'un acide capable de provoquer la polymérisation de la matière polymérisable cationiquement.

2. Compositions selon la revendication 1 dans

lesquelles $R^9$, g et $R^{10}$ forment, avec les atomes de carbone représentés sur la formule, un noyau cyclohexényle, tétrahydropyrimidinyle ou pyrannyle.

3. Compositions selon l'une des revendications 1 et 2, dans lesquelles $R^{11}$ représente un atome d'hydrogène, un radical hydroxy ou un radical méthyle.

4. Compositions selon l'une quelconque des revendications 1 à 3, dans lesquelles Ar représente un radical phényle non substitué.

5. Compositions selon l'une quelconque des revendications 1 à 4, dans lesquelles l'anion $Y^{x-}$ dérive d'un acide carboxylique organique, d'un acide sulfonique organique $R^{12}SO_3H$ dans lequel $R^{12}$ représente un radical aliphatique, un radical aromatique ou un radical aromatique porteur d'un substituant aliphatique, chacun de ces radicaux pouvant porter un ou plusieurs atomes d'halogènes, ou dérive d'un acide minéral.

6. Compositions selon la revendication 5 dans lesquelles l'anion $Y^{x-}$ est un anion acétate, trifluoracétate, méthane-sulfonate, benzène-sulfonate, p-toluène-sulfonate, trifluorométhane-sulfonate, fluorate, chlorure, bromure, iodate, perchlorate, nitrate, sulfate, hydrogéno-sulfate, phosphate, hydrogénophosphate ou pentafluoro-hydroxo-antimoniate, ou encore un anion répondant à la formule $MQ_w^-$ dans laquelle M représente un atome de métal ou de métalloïde, Q représente un atome d'halogène et w représente un nombre entier de 4 à 6 et est supérieur d'une unité à la valence de M.

7. Compositions selon la revendication 6 dans lesquelles l'anion $Y^{x-}$ est un anion hexafluoro-antimoniate, hexachloro-antimoniate, hexafluoro-arséniate, pentachlorobismuthate, tétrachloroferrate, hexachlorostannate, tétrafluoroborate ou hexafluorophosphate.

8. Compositions selon l'une quelconque des revendications 1 à 7, qui contiennent, comme matière photopolymérisable cationiquement, un mono-époxyde en 1,2 ou une résine époxydique et dans lesquelles le sel d'iodonium a un anion d'halogénure de métal ou d'halogénure de métalloïde.

9. Compositions selon l'une quelconque des revendications 1 à 6, qui contiennent, comme matière polymérisable cationiquement, un aminoplaste ou un phénoplaste et, comme sel d'iodonium, un acétate, un trifluoracétate, un méthanesulfonate, un benzène-sulfonate, un p-toluène-sulfonate, un trifluorométhane-sulfonate, un fluorure, un chlorure, un bromure, un iodate, un perchlorate, un nitrate, un sulfate, un hydrogénosulfate, un phosphate ou un hydrogénophosphate.

10. Compositions selon l'une quelconque des revendications 1 à 9, qui contiennent une résine époxydique ou un phénoplaste, et une quantité, efficace pour le durcissement, d'un thermodurcisseur latent pour la résine époxydique ou le phénoplaste.

11. Procédé de préparation d'une matière polymère ou réticulée, procédé caractérisé en ce qu'on expose une composition selon l'une quelconque des revendications précédentes à un rayonnement d'une longueur d'onde telle que la composition subisse une polymérisation ou une réticulation.

12. Procédé selon la revendication 11 caractérisé en ce que la composition est une composition selon la revendication 10 et en ce qu'on chauffe le produit irradié pour durcir la résine époxydique ou le phénoplaste.

13. Application des compositions selon la revendication 1 pour la réalisation de revêtements, pour la fabrication de clichés d'impression ou de circuits imprimés, et comme colles.